# EUROPEAN PATENT SPECIFICATION

(11) **EP 4 271 159 B1**
(45) Date of publication and mention of the grant of the patent: **22.07.2026**
(21) Application number: 21966073.5
(22) Date of filing: 03.12.2021
(51) Int. Cl.: H10K 30/86, H10K 85/50, H10K 30/40, H10K 101/40

(54) **PEROVSKITE SOLAR CELL, AND PHOTOVOLTAIC ASSEMBLY**
PEROWSKIT-SOLARZELLE UND PHOTOVOLTAIK-ANLAGE
CELLULE SOLAIRE EN PÉROVSKITE ET ENSEMBLE PHOTOVOLTAÏQUE

(43) Date of publication of application: 01.11.2023
(73) Proprietor: Contemporary Amperex Technology (Hong Kong) Limited, Central, Central And Western District (HK)
(72) Inventor: CHEN, Changsong, Ningde, Fujian 352100 (CN); GUO, Wenming, Ningde, Fujian 352100 (CN); TU, Bao, Ningde, Fujian 352100 (CN); GUO, Yongsheng, Ningde, Fujian 352100 (CN); CHEN, Guodong, Ningde, Fujian 352100 (CN); OUYANG, Chuying, Ningde, Fujian 352100 (CN)
(74) Representative: Gong, Jinping
(86) International application number: PCT/CN2021/135304
(87) International publication number: WO 2023/097646

(56) References cited:
- WO-A1-2020/175501
- CN-A- 105 405 973
- CN-A- 105 405 973
- CN-A- 109 216 551
- CN-A- 111 446 369
- US-A1- 2020 381 185
- EOM TAEYONG ET AL: "Copper Oxide Buffer Layers by Pulsed-Chemical Vapor Deposition for Semitransparent Perovskite Solar Cells", vol. 8, no. 1, 16 November 2020 (2020-11-16), DE, XP093142052, ISSN: 2196-7350, Retrieved from the Internet <URL:https://onlinelibrary.wiley.com/doi/full-xml/10.1002/admi.202001482> DOI: 10.1002/admi.202001482
- EOM TAEYONG ET AL: "Supporting Information: Copper Oxide Buffer Layers by Pulsed-Chemical Vapor Deposition for Semitransparent Perovskite Solar Cells", ADVANCED MATERIALS INTERFACES, vol. 8, no. 1, 16 November 2020 (2020-11-16), DE, XP093142056, ISSN: 2196-7350, Retrieved from the Internet <URL:https://onlinelibrary.wiley.com/doi/full-xml/10.1002/admi.202001482> DOI: 10.1002/admi.202001482
- CHIANG YU-HSIEN ET AL: "Highly stable perovskite solar cells with all-inorganic selective contacts from microwave-synthesized oxide nanoparticles", JOURNAL OF MATERIALS CHEMISTRY A, vol. 5, no. 48, 1 January 2017 (2017-01-01), GB, pages 25485 - 25493, XP093142064, ISSN: 2050-7488, DOI: 10.1039/C7TA07775K

## Description

### Technical Field

The present application belongs to the technical field of solar batteries, and specifically relates to a perovskite solar battery as specified in any of claims 1-12 and a photovoltaic assembly as specified in claim 13.

### Background Art

With the development of modern industry, the problems of global energy shortage and environmental pollution have become increasingly prominent, and solar batteries have attracted more and more attentions as an ideal renewable energy source. A solar battery, also known as a photovoltaic battery, is an apparatus that directly converts light energy into electrical energy through photoelectric effects or photochemical effects. Improving the photoelectric conversion efficiency of solar batteries has always been the striving direction of researchers. A perovskite solar battery is a solar battery in which a perovskite material is used as a light absorbing layer, which has rapidly achieved high photoelectric conversion efficiency within a few years after emergence, and has attracted extensive attentions in recent years. After absorbing incident sunlight, the perovskite material will be excited to generate electron-hole pairs, and then the electron-hole pairs are separated into electrons and holes, which will be transported to the cathode and the anode, respectively. How to accelerate the transport of holes and prevent the recombination of electrons and holes is crucial for improving the photoelectric conversion efficiency of the perovskite solar battery. EOM TAEYONG ET AL: "Copper Oxide Buffer Layers by Pulsed-Chemical Vapor Deposition for Semitransparent Perovskite Solar Cell", ADVANCED MATERIALS INTERFACES, describes a fabricate semitransparent solar cell devices: glass/FTO/bl-TiO2/mp-TiO2/perovskite/PTAA/buffer/ITO/Au. WO 2020/175501A1 describes a solar cell element 20 includes: a first electrode 21, a first carrier transporter 22, a light-absorbing layer 23, a second carrier transporter 24, and a second electrode 25. CHIANY YU-HSIEN ET AL: "Highly stable perovskite solar cells with all-inorganic selective contacts from microwave-synthesized oxide nanoparticles", JOURNAL OF MATERIALS CHEMISTRY A, describes a perovskite structure: FTO/NiO_{(Compact)}/NiO₍ₘₑₛₒₚₒᵣₒᵤₛ₎/perovskite layer/IZO nanoparticle/Al.

CN105405973A describes a mesoscopic solar cell based on a perovskite-type light-absorbing material.

CN109216551A describes a solar cell comprising a first hole transport layer and a second hole transport layer.

### Summary of the Invention

An object of the present application is to provide a perovskite solar battery as specified in any of claims 1-12 and a photovoltaic assembly as specified in claim 13, so as to improve the hole extraction and transport efficiency of the hole transport layer, improve the open voltage and current of the perovskite solar battery, and improve the photoelectric conversion efficiency and service life of the perovskite solar battery.

A first aspect of the present application provides a perovskite solar battery as specified in any of claims 1-12, including a first electrode, a second electrode, and a light absorbing layer between the first electrode and the second electrode, where the perovskite solar battery further includes a first hole transport layer and a second hole transport layer, where the first hole transport layer is located between the second hole transport layer and the light absorbing layer, and the second hole transport layer is located between the first electrode and the light absorbing layer, or the second hole transport layer is located between the second electrode and the light absorbing layer. A first hole transport material of the first hole transport layer is selected from one of PTAA, and nickel oxide that is doped with a first doping element or is undoped, and a second hole transport material of the second hole transport layer includes at least one of a P-type transition metal oxide semiconductor material and a P-type transition metal halide semiconductor material capable of isolating water and oxygen; wherein the second hole transport material includes at least one of: MoO₃, CuO, Cu₂O, CuI, CuGaO₂, CuGrO₂, and CoO that is doped with a second doping element; and wherein the second doping element includes at least one of an alkali metal element, a post-transition metal element, a metalloid element, a halogen element, a nonmetallic element, an ionic liquid, a carboxylic acid, phosphoric acid, a carbon derivative, a self-assembled monomolecule, and a polymer.

In the perovskite solar battery of the present application, the first hole transport material is close to the light absorbing layer, and can efficiently extract holes in the light absorbing layer. The second hole transport material has better surface wettability and better film-forming properties, thereby contributing to improving the bonding strength between the whole hole transport layer and the electrode. The second hole transport material further can form a protective passivation layer on the surface of the first hole transport layer to passivate the surface of the first hole transport layer and prevent the first hole transport material from being denatured or degraded due to contact with air. In addition, the protective passivation layer further can isolate water and oxygen to prevent water and oxygen from corroding the first hole transport material, thereby making better use of the hole extraction and transport capability of the first hole transport material. The second hole transport material further can improve the overall conductivity performance of the hole transport layer, thereby further improving the hole extraction and transport efficiency. The second hole transport material has fewer internal defects within the crystal, and further can block the further migration of charged halogen ions, thereby improving the stability of the perovskite solar battery. Therefore, the present application can effectively reduce the recombination of electrons and holes, and improve the hole extraction and transport efficiency, to transport more holes to one of the first electrode and the second electrode, thereby further improving the open voltage and current of the perovskite solar battery, and improving the photoelectric conversion efficiency and service life of the perovskite solar battery.

In any embodiment of the present application, a difference value ΔVBM1 between a top energy level of a valence band of the second hole transport layer and a top energy level of a valence band of the first hole transport layer is from -1.0 eV to 1.0 eV. In the perovskite solar battery of the present application, the second hole transport layer and the first hole transport layer have suitable difference values of the top energy level of the valence band, and the whole hole transport layer has a suitable energy level gradient, thereby contributing to reducing the recombination of electrons and holes, improving hole the extraction and transport efficiency, and reducing the energy loss. A very large difference value between the top energy level of the valence band of the second hole transport layer and the top energy level of the valence band of the first hole transport layer will cause excessive hole transition energy loss between energy levels. Optionally, the difference value ΔVBM1 between the top energy level of the valence band of the second hole transport layer and the top energy level of the valence band of the first hole transport layer is from -0.3 eV to 0.3 eV. A smaller difference value between the top energy level of the valence band of the second hole transport layer and the top energy level of the valence band of the first hole transport layer contributes to further reducing the recombination of electrons and holes, improving the hole transport efficiency, and reducing the energy loss.

In any embodiment of the present application, the first doping element includes at least one of an alkali metal element, an alkali earth metal element, a transition metal element, and a halogen element. Optionally, the alkali metal element includes at least one of Li, Na, K, Rb, and Cs. Optionally, the alkali earth metal element includes at least one of Be, Mg, Ca, Sr, and Ba. Optionally, the transition metal element includes at least one of Ti, Cr, Mn, Fe, Co, Ni, Cu, Zn, Zr, Nb, Mo, Ru, Rh, Pd, Ag, Cd, Ta, Pt, and Au. Optionally, the halogen element includes at least one of F, Cl, Br, and I. After nickel oxide is doped with the first doping element, the photoelectric properties of the first hole transport layer can be changed, so that the energy level of the first hole transport layer can better match the energy level of the light absorbing layer, thus improving the hole extraction efficiency, and finally improving the photoelectric conversion efficiency of the perovskite solar battery.

In any embodiment of the present application, based on a total mass of the first hole transport material, a percentage mass content of the first doping element is less than or equal to 20%. Optionally, the percentage mass content of the first doping element is from 5% to 15%. Selecting an appropriate doping amount contributes to better adjustment of the energy band position of the first hole transport layer. If the percentage mass content of the first doping element is very high, the crystal structure of nickel oxide may be damaged, thus resulting in a large deviation of the energy band structure, and affecting the hole extraction and transport capability of the first hole transport layer.

These hole transport materials can better isolate water and oxygen, inhibit the corrosion of water and oxygen to the first hole transport material, and improve the hole transport efficiency.

In the present application, in the second doping element, the alk ali metal element includes at least one of Li, Na, K, Rb, and Cs; the post-transition metal element includes at least one of Al, Ga, In, Sn, Tl, Pb, and Bi; the metalloid element includes at least one of B, Si, Ge, As, Sb, and Te; the halogen element includes at least one of F, Cl, Br, and I; the no nmetallic element includes at least one of P, S, and Se; the ionic liquid includes at least one of 1-butyl-3-methylimidazolium tetrafluoroborate, NH₄Cl, (NH₄)₂S, tetramethylammonium hydroxide aqueous solution, and trifluoroethanol; the carboxylic acid includes at least one of ethylenediami netetraacetic acid, diethylenetriaminepentaacetic acid, 4-imidazoleacetic acid hydrochloride, and acetic acid; the carbon derivative includes at least one of carbon quantum dot, carbon nanotube, g raphene, C₆₀, g-C₃N₄, C₉, NPC₆₀-OH, and DPC₆₀; the self-assembled monomolecule includes at 1 east one of 2-phenethylamine hydroiodide, N,N-diethylaniline, 9,9-bis(4-aminophenyl)fluorene, 4-picolinic acid, dopamine, 3-aminopropyltriethoxysilane, and glycine; and the polymer includes at least one of styrene, polyethyleneimine, polyethylene oxide, and tris(N,N-tetramethylene)phos phoric acid triamide.

The second hole transport material can be doped to adjust the energy band position of the second hole transport layer, such that the second hole transport layer and the first hole transport layer have suitable difference values of the top energy level of the valence band and suitable energy level gradients, thereby reducing the recombination of electrons and holes, improving the hole extraction and transport efficiency, and improving the open voltage and current of the perovskite solar battery. Doping the second hole transport material further can improve its conductivity performance.

In any embodiment of the present application, based on a total mass of the second hole transport material, a percentage mass content of the second doping element is less than or equal to 30%. Optionally, the percentage mass content of the second doping element is from 5% to 25%. Selecting an appropriate doping amount contributes to better adjustment of the energy band position of the second hole transport layer, such that the second hole transport layer and the first hole transport layer have suitable difference values of the top energy level of the valence band and suitable energy level gradients, thereby reducing the recombination of electrons and holes, and improving the hole extraction and transport efficiency.

In any embodiment of the present application, a difference value ΔVBM2 between the top energy level of the valence band of the first hole transport layer and a top energy level of a valence band of the light absorbing layer is from -1.0 eV to 1.0 eV. Optionally, the difference value ΔVBM2 between the top energy level of the valence band of the first hole transport layer and the top energy level of the valence band of the light absorbing layer is from -0.3 eV to 0.3 eV. The difference value between the top energy level of the valence band of the first hole transport layer and the top energy level of the valence band of the light absorbing layer in an appropriate range contributes the first hole transport layer to more efficiently extracting holes in the light absorbing layer.

In any embodiment of the present application, a difference value between a top energy level of a conduction band of the second hole transport layer and a top energy level of a conduction band of the light absorbing layer is greater than or equal to 0.5 eV. The difference value between the top energy level of the conduction band of the second hole transport layer and the top energy level of the conduction band of the light absorbing layer in an appropriate range can block the electron transport, and reduce the recombination of electrons and holes.

In any embodiment of the present application, a difference value between a top energy level of a conduction band of the first hole transport layer and the top energy level of the conduction band of the light absorbing layer is greater than or equal to 0.5 eV. The difference value between the top energy level of the conduction band of the first hole transport layer and the top energy level of the conduction band of the light absorbing layer in an appropriate range can block the electron transport, and reduce the recombination of electrons and holes.

In any embodiment of the present application, a difference value between a Fermi level and the top energy level of the valence band of the second hole transport layer is less than or equal to 1.5 eV. A small difference value between the Fermi level and the top energy level of the valence band of the second hole transport layer can guarantee that the second hole transport layer has better P-type semiconductor properties, and facilitate improving the hole transport capability.

In any embodiment of the present application, a difference value between a Fermi level and the top energy level of the valence band of the first hole transport layer is less than or equal to 1.5 eV. A small difference value between the Fermi level and the top energy level of the valence band of the first hole transport layer can guarantee that the first hole transport layer has better P-type semiconductor properties, and facilitate improving the hole extraction and transport capability.

In any embodiment of the present application, a band gap of the second hole transport layer is greater than or equal to 1.5 eV. The second hole transport layer with a large band gap can better filter ultraviolet light, and reduce the damage of the ultraviolet light to a light absorbing material.

In any embodiment of the present application, thickness of the second hole transport layer is from 1 nm to 300 nm. Optionally, the thickness of the second hole transport layer is from 1 nm to 100 nm.

In any embodiment of the present application, thickness of the first hole transport layer is from 5 nm to 1,000 nm. Optionally, the thickness of the first hole transport layer is from 10 nm to 200 nm.

In any embodiment of the present application, a ratio of the thickness of the first hole transport layer to the thickness of the second hole transport layer is from 1:1 to 10:1. Compared with the first hole transport layer, the second hole transport layer is thinner, and can form a more compact and more stable film, thereby contributing to improving the hole transport rate.

In non-claimed embodiment of the present application, the light absorbing layer comprises a perovskite material.

In any embodiment of the present application, one of the first electrode and the second electrode is a transparent electrode. Optionally, the transparent electrode is an FTO electrode or an ITO electrode.

In any embodiment of the present application, one of the first electrode and the second electrode is a metal electrode or a conductive carbon electrode. Optionally, the metal electrode is selected from one or more of a gold electrode, a silver electrode, an aluminum electrode, and a copper electrode.

In any embodiment of the present application, the perovskite solar battery further includes an electron transport layer, the electron transport layer is located between the light absorbing layer and the second electrode or the first electrode, and the light absorbing layer is located between the first hole transport layer and the electron transport layer. The electron transport layer can reduce a potential barrier between the electrode and the light absorbing layer, promote the transport of electrons, effectively block holes, and inhibit the recombination of electrons and holes.

A second aspect of the present application provides a photovoltaic assembly as specified in claim 13, comprising the perovskite solar battery in the first aspect of the present application.

The photovoltaic assembly of the present application comprises the perovskite solar battery provided in the present application, and thus has at least the same advantages as the perovskite solar battery.

### Description of Drawings

In order to more clearly illustrate the technical solutions in examples of the present application, the accompanying drawings to be used in the examples of the present application will be briefly introduced below. Apparently, the drawings described below are merely some embodiments of the present application. For those of ordinary skills in the art, other drawings may also be obtained based on these drawings without making creative work.
Fig. 1 is a schematic structural diagram of a perovskite solar battery in an embodiment of the present application.
Fig. 2 is a schematic structural diagram of the perovskite solar battery in another embodiment of the present application.

### Detailed Description

Embodiments of a perovskite solar battery and a photovoltaic assembly of the present application are specifically disclosed below with reference to detailed description of the accompanying drawings. However, unnecessary detailed description will be omitted in some cases. For example, there are cases where detailed descriptions of well-known items and repeated descriptions of actually identical structures are omitted. This is to avoid unnecessary redundancy in the following descriptions and to facilitate the understanding by those skilled in the art. In addition, the drawings and subsequent descriptions are provided for those skilled in the art to fully understand the present application, and are not intended to limit the subject matter recited in the claims.

"Ranges" disclosed in the present application are defined in the form of lower limits and upper limits, a given range is defined by the selection of a lower limit and an upper limit, and the selected lower and upper limits define boundaries of the particular range. A range defined in this manner may be inclusive or exclusive of end values, and may be arbitrarily combined, that is, any lower limit may be combined with any upper limit to form a range. For example, if the ranges of 60-120 and 80-110 are listed for a particular parameter, it is understood that the ranges of 60-110 and 80-120 are also contemplated. Additionally, if the minimum range values 1 and 2 are listed, and if the maximum range values 3, 4, and 5 are listed, the following ranges are all contemplated: 1-3, 1-4, 1-5, 2-3, 2-4 and 2-5. In the present application, unless stated otherwise, the numerical range "a-b" represents an abbreviated representation of any combination of real numbers between a and b, where both a and b are real numbers. For example, the numerical range "0-5" means that all real numbers between "0-5" have been listed herein, and "0-5" is just an abbreviated representation of the combination of these numerical values. In addition, when a parameter is expressed as an integer greater than or equal to 2, it is equivalent to disclosing that the parameter is, for example, an integer of 2, 3, 4, 5, 6, 7, 8, 9, 10, 11, 12, and the like.

Unless otherwise specifically stated, all embodiments and optional embodiments of the present application may be combined with each other to form new technical solutions, and such technical solutions should be considered as being included in the disclosure of the present application.

Unless otherwise specifically stated, all technical features and optional technical features of the present application may be combined with each other to form new technical solutions, and such technical solutions should be considered as being included in the disclosure of the present application.

Unless otherwise specifically stated, all steps in the present application may be performed sequentially or randomly, and are preferably performed sequentially. For example, the method includes steps (a) and (b), indicating that the method may include steps (a) and (b) performed sequentially, or may include steps (b) and (a) performed sequentially. For example, reference to the method may further include step (c), indicating that step (c) may be added to the method in any order, e.g., the method may include steps (a), (b), and (c), or may include steps (a), (c), and (b), or may include steps (c), (a), and (b).

Unless otherwise specifically stated, the "including" and "comprising" mentioned in the present application mean open-ended, or may be closed-ended. For example, the "including" and "comprising" may indicate that it is possible to include or comprise other components not listed, and it is also possible to include or comprise only the listed components.

Unless otherwise specified, the term "or" is inclusive in the present application. By way of example, the phrase "A or B" means "A, B, or both A and B." More specifically, the condition "A or B" is satisfied under any one of the following conditions: A is true (or present) and B is false (or absent); A is false (or absent) and B is true (or present); or both A and B are true (or present).

A perovskite solar battery is a solar battery in which a perovskite material is used as a light absorbing layer. Sunlight incident to the light absorbing layer is immediately absorbed by the perovskite material. The energy of photons excites electrons originally bound around the nucleus, making them form free electrons, and when an electron is excited, a hole will be generated simultaneously, thereby forming an electron-hole pair. The electron-hole pairs are separated into electrons and holes, which flow to the cathode and the anode of the perovskite solar battery, respectively. The process of electron and hole transport is inevitably accompanied with the loss of some current carriers, such as the recombination of electrons and holes. The hole transport layer is an important functional layer of the perovskite solar battery, and functions for extracting and transporting holes, whist blocking electrons, and preventing the recombination of electrons and holes, and is crucial for improving the photoelectric conversion efficiency of the perovskite solar battery.

In a hole transport layer of the perovskite solar battery, nickel oxide (NiOₓ) is generally used as an inorganic hole transport material, and poly[bis(4-phenyl)(2,4,6-trimethylphenyl)amine] (PTAA) is generally used as an organic hole transport material. The two materials are inexpensive, and have high structural stability. Nickel oxide and PTAA further have suitable work functions and energy band positions, and can better match the energy level structure of the perovskite material in the light absorbing layer, to guarantee the hole extraction and transport. However, nickel oxide and PTAA have poor surface wettability after film formation, which affects the quality of the film layer. In addition, Ni³⁺ in the bulk phase of nickel oxide after film formation enables it to conduct hole conduction, and a part of the Ni³⁺ existing on the surface easily reacts with oxygen in the environment to generate NiO and NiOOH, thereby not only increasing the surface resistivity of the hole transport layer, but also failing to contribute to the hole extraction and transport. As a polymer-type hole transport material, PTAA generally has a high resistivity, and fails to contribute to the hole extraction and transport.

In view of the above problems, the inventors improved the structure of the hole transport layer.

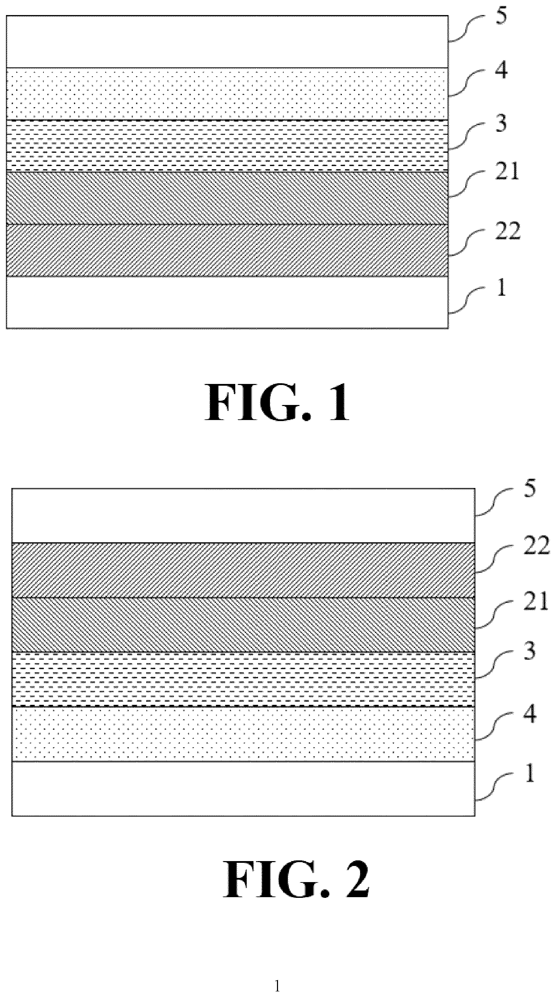

A first aspect of embodiments of the present application provides a perovskite solar battery. Fig. 1 is a schematic structural diagram of a perovskite solar battery in an embodiment of the present application, and Fig. 2 is a schematic structural diagram of the perovskite solar battery in another embodiment of the present application. As show in Fig. 1 and Fig. 2, the perovskite solar battery includes a first electrode 1, a second electrode 5, and a light absorbing layer 3 between the first electrode 1 and the second electrode 5, the perovskite solar battery further includes a first hole transport layer 21 and a second hole transport layer 22, and the first hole transport layer 21 is located between the second hole transport layer 22 and the light absorbing layer 3. As shown in Fig. 1, the second hole transport layer 22 is located between the first electrode 1 and the light absorbing layer 3. As shown in Fig. 2, the second hole transport layer 22 is located between the second electrode 5 and the light absorbing layer 3.

A first hole transport material of the first hole transport layer 21 is selected from one of PTAA, and nickel oxide that is doped with a first doping element or is undoped. A second hole transport material of the second hole transport layer 22 is selected from at least one of a P-type transition metal oxide semiconductor material and a P-type transition metal halide semiconductor material capable of isolating water and oxygen.

The first hole transport material is close to the light absorbing layer, and can efficiently extract holes in the light absorbing layer, while the second hole transport material has better surface wettability and better film-forming properties, thereby contributing to improving the bonding strength between the whole hole transport layer and the electrode (e.g., the first electrode or the second electrode).

The second hole transport material further can form a protective passivation layer on the surface of the first hole transport layer to passivate the surface of the first hole transport layer, and prevent the first hole transport material from being denatured or degraded due to contact with air (e.g., a part of the Ni³⁺ existing on the surface of nickel oxide easily reacts with oxygen in the environment to generate NiO and NiOOH), thereby affecting the hole extraction and transport by the first hole transport layer. A second hole transport material is selected from at least one of a P-type transition metal oxide semiconductor material and a P-type transition metal halide semiconductor material capable of isolating water and oxygen. Therefore, the second hole transport material further can inhibit the corrosion of water and oxygen to the first hole transport material (e.g., PTAA or nickel oxide). Therefore, after the first hole transport layer and the second hole transport layer are recombined, the hole extraction and transport capability of the first hole transport layer can be better used. Ni²⁺ and oxygen vacancies existing on the shallow surface of nickel oxide after film formation will reduce the quantity of electric charge, and fail to contribute to the hole extraction and transport. Transition metal cations in the second hole transport material can diffuse into the shallow surface of nickel oxide to a certain extent, and function for supplementing related charge losses and vacancies, passivating the surface of nickel oxide, and isolating water and oxygen, so as to make better use of the hole extraction and transport capability of nickel oxide.

After forming the protective passivation layer on the surface of nickel oxide, the second hole transport material further can reduce the surface resistivity of nickel oxide, and improve the surface conductivity performance of the first hole transport layer and the overall conductivity performance of the hole transport layer, thereby further improving the hole extraction and transport efficiency. In addition, as the polymer-type hole transport material, PTAA generally has a high resistivity, and can, after recombination of the first hole transport layer and the second hole transport layer, improve the overall conductivity performance of the hole transport layer, thereby further improving the hole extraction and transport efficiency.

A light absorbing material of the perovskite solar battery is generally a halide perovskite material (e.g., an inorganic halide perovskite material, an organic halide perovskite material, or an organic-inorganic hybrid halide perovskite material), and has attracted extensive attentions due to its advantages, such as large carrier diffusion length, easily regulatable band gap, high defect tolerance, and low manufacturing costs. However, the halide perovskite material itself has poor stability, and tends to decompose under the action of water and oxygen, thereby accelerating the aging of the perovskite solar battery. Ion migration is another important property of the halide perovskite material. The migration and accumulation of charged ions will lead to significant changes of the doping concentration of the light absorbing layer and the built-in electric field, and even will cause local crystal structure changes. Ion migration and aggregation further may cause local chemical doping effects, change the Fermi level of the ion aggregation region, and bend the energy level, thus affecting the separation, transport, and extraction of photogenerated carriers. There is a close relation between ion migration and defects. Internal defects of crystal provide a migration route for ions. In the perovskite solar battery of embodiments of the present application, the second hole transport material has fewer internal defects of crystal, and compared with the first hole transport layer, the second hole transport layer is more compact and more stable, and can block the further migration of charged halogen ions, thereby improving the stability of the perovskite solar battery.

Therefore, the perovskite solar battery of the present application can effectively reduce the recombination of electrons and holes, and improve the extraction and transport efficiency of holes, to transport more holes to one of the first electrode and the second electrode, thereby further improving the open voltage and current of the perovskite solar battery, and improving the photoelectric conversion efficiency and service life of the perovskite solar battery.

In some embodiments, the first hole transport material is selected from nickel oxide that is doped with the first doping element. After nickel oxide is doped with the first doping element, the photoelectric properties, such as the transparency, energy band structure, work function, carrier density, and conductivity, of the first hole transport layer can be changed, so that an energy level of the first hole transport layer can better match an energy level of the light absorbing layer, thus improving the hole extraction efficiency, and finally improving the photoelectric conversion efficiency of the perovskite solar battery.

In some embodiments, the first doping element includes at least one of an alkali metal element, an alkali earth metal element, a transition metal element, and a halogen element. Selecting an appropriate first doping element contributes to better adjustment of the energy band position of the first hole transport layer.

As an example, the alkali metal element includes at least one of Li, Na, K, Rb, and Cs. Optionally, the alkali metal element includes at least one of Li, Na, and K.

As an example, the alkali earth metal element includes at least one of Be, Mg, Ca, Sr, and Ba. Optionally, the alkali earth metal element includes at least one of Be, Mg, and Ca. Further, the alkali earth metal element includes Mg.

As an example, the transition metal element includes at least one of Ti, Cr, Mn, Fe, Co, Cu, Zn, Zr, Nb, Mo, Ru, Rh, Pd, Ag, Cd, Ta, Pt, and Au. Optionally, the transition metal element includes at least one of Ti, Cr, Mn, Fe, Co, Cu, and Mo. Further, the transition metal element includes at least one of Co and Cu.

As an example, the halogen element includes at least one of F, Cl, Br, and I. Optionally, the halogen element includes at least one of F and Cl.

The form of the first doping element is not particularly limited, for example, may be in the form of atoms, molecules, or ions. As an example, a precursor for forming the first doping element includes, but is not limited to, at least one of an alkali metal element, an alkali earth metal element, a transition metal element, a halogen element, an alkali metal halide, an alkali earth metal halide, and a transition metal halide.

In some examples, based on a total mass of the first hole transport material, a percentage mass content of the first doping element is less than or equal to 20%. For example, the percentage mass content of the first doping element is 0%, 1%, 2%, 3%, 4%, 5%, 6%, 7%, 8%, 9%, 10%, 11%, 12%, 13%, 14%, 15%, 16%, 17%, 18%, 19%, or 20%, or a range composed of the above values. Optionally, the percentage mass content of the first doping element is 1%-20%, 2%-20%, 3%-20%, 4%-20%, 5%-20%, 1%-15%, 2%-15%, 3%-15%, 4%-15%, 5%-15%, 1%-10%, 2%-10%, 3%-10%, 4%-10%, 1%-5%, 2%-5%, 3%-5%, or 4%-5%. Selecting an appropriate doping amount contributes to better adjustment of the energy band position of the first hole transport layer. If the percentage mass content of the first doping element is very high, the crystal structure of nickel oxide may be damaged, thus resulting in a large deviation of the energy band structure, and affecting the hole extraction and transport capability of the first hole transport layer.

The type and content of the first doping element may be selected as required, and the first doping element may be of one type or a combination of multiple types.

The second hole transport material of the second hole transport layer 22 includes at least one of: MoO₃, CuO, Cu₂O, CuI, CuGaO₂, CuGrO₂, and CoO that is doped with a second doping element or is undoped. These hole transport materials can better isolate water and oxygen, inhibit the corrosion of water and oxygen to the first hole transport material (e.g., PTAA and nickel oxide), and improve the hole transport efficiency. Transition metal cations in these hole transport materials are close to the radius of a nickel ion, can better diffuse into the shallow surface of nickel oxide, and function for supplementing related charge losses and vacancies, passivating the surface of nickel oxide, and isolating water and oxygen.

The second hole transport material is doped with the second doping element. The second hole transport material can be doped to adjust the energy band position of the second hole transport layer, such that the second hole transport layer and the first hole transport layer have suitable difference values of the top energy level of the valence band and suitable energy level gradients, thereby reducing the recombination of electrons and holes, improving the hole extraction and transport efficiency, and improving the open voltage and current of the perovskite solar battery. Doping the second hole transport material further can improve its conductivity performance.

The second doping element includes at least one of an alkali metal element, an alkali earth metal element, a transition metal element, a post-transition metal element, a metalloid element, a halogen element, a nonmetallic element, an ionic liquid, a carboxylic acid, phosphoric acid, a carbon derivative, a self-assembled monomolecule, and a polymer. Selecting an appropriate second doping element contributes to better adjustment of the energy band position of the second hole transport layer.

As an example, the alkali metal element includes at least one of Li, Na, K, Rb, and Cs. Optionally, the alkali metal element includes at least one of Li, Na, and K.

As an example, the alkali earth metal element includes at least one of Be, Mg, Ca, Sr, and Ba. Optionally, the alkali earth metal element includes at least one of Be, Mg, and Ca. Further, the alkali earth metal element includes Mg.

As an example, the transition metal element includes at least one of Ti, Cr, Mn, Fe, Co, Ni, Cu, Zn, Zr, Nb, Mo, Ru, Rh, Pd, Ag, Cd, Ta, Pt, and Au. Optionally, the transition metal element includes at least one of Ti, Cr, Mn, Fe, Co, Ni, Cu, and Mo. Further, the transition metal element includes at least one of Co and Cu.

As an example, the post-transition metal element includes at least one of Al, Ga, In, Sn, Tl, Pb, and Bi. Optionally, the post-transition metal element includes at least one of Al and Ca. Further, the post-transition metal element includes Al.

As an example, the metalloid element includes at least one of B, Si, Ge, As, Sb, and Te. Optionally, the metalloid element includes at least one of B and Sb. Further, the metalloid element includes B.

As an example, the halogen element includes at least one of F, Cl, Br, and I. Optionally, the halogen element includes at least one of F and Cl.

As an example, the nonmetallic element includes at least one of P, S, and Se. Optionally, the nonmetallic element includes P.

As an example, the ionic liquid includes at least one of 1-butyl-3-methylimidazolium tetrafluoroborate (BMIMBF₄), NH₄Cl, (NH₄)₂S, tetramethylammonium hydroxide aqueous solution (TMAH), and trifluoroethanol. Optionally, the ionic liquid includes at least one of BMIMBF₄ and NH₄Cl. Further, the ionic liquid includes NH₄Cl.

As an example, the carboxylic acid includes at least one of ethylenediaminetetraacetic acid (EDTA), diethylenetriaminepentaacetic acid (DTPA), 4-imidazoleacetic acid hydrochloride (ImAcHCl), and acetic acid. Optionally, the carboxylic acid includes EDTA.

As an example, the carbon derivative includes at least one of carbon quantum dot, carbon nanotube, graphene, C₆₀, g-C₃N₄, C₉, NPC₆₀-OH, and DPC₆₀. Optionally, the carbon derivative includes the carbon quantum dot.

As an example, the self-assembled monomolecule includes at least one of 2-pheny lethylamine hydroiodide (PEAI), N,N-diethylaniline (DEA), 9,9-bis(4-aminophenyl)fluorene (FD A), 4-picolinic acid, dopamine, 3-aminopropyltriethoxysilane (APTES), and glycine. Optionally, the self-assembled monomolecule includes at least one of PEAI, DEA, FDA, and dopamine. Furt her, the self-assembled monomolecule includes PEAI.

As an example, the polymer includes at least one of polystyrene (PS), polyethyleneimine (PEIE), polyethylene oxide (PEO), and tris(N,N-tetramethylene)phosphoric acid triamide (TPPO). Optionally, the polymer includes PEIE.

The form of the second doping element is not particularly limited, for example, may be in the form of atoms, molecules, or ions. As an example, a precursor for forming the second doping element includes, but is not limited to, at least one of an alkali metal element, an alkali earth metal element, a transition metal element, a post-transition metal element, a metalloid element, a halogen element, a nonmetallic element, an ionic liquid, a carboxylic acid, phosphoric acid, a carbon derivative, a self-assembled monomolecule, a polymer, an alkali metal halide, an alkali earth metal halide, a transition metal halide, a post-transition metal halide, and a metalloid halide.

In some examples, based on a total mass of the second hole transport material, a percentage mass content of the second doping element is less than or equal to 30%. For example, the percentage mass content of the second doping element is 0%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, or 30%, or a range composed of the above values. Optionally, the percentage mass content of the second doping element is 1%-30%, 2%-30%, 3%-30%, 4%-30%, 5%-30%, 1%-25%, 2%-25%, 3%-25%, 4%-25%, 5%-25%, 1%-20%, 2%-20%, 3%-20%, 4%-20%, 5%-20%, 1%-15%, 2%-15%, 3%-15%, 4%-15%, 5%-15%, 1%-10%, 2%-10%, 3%-10%, 4%-10%, 1%-5%, 2%-5%, 3%-5%, or 4%-5%. Selecting an appropriate doping amount contributes to better adjustment of the energy band position of the second hole transport layer, such that the second hole transport layer and the first hole transport layer have suitable difference values of the top energy level of the valence band and suitable energy level gradients, thereby reducing the recombination of electrons and holes, and improving the hole extraction and transport efficiency. If the percentage mass content of the second doping element is very high, the crystal structure of the second hole transport material may be damaged, thus resulting in a large deviation of the energy band structure, and affecting the performance of the second hole transport layer.

The type and content of the second doping element may be selected as required, and the second doping element may be of one type or a combination of multiple types.

In some examples, a difference value ΔVBM1 between a top energy level of a valence band of the second hole transport layer 22 and a top energy level of a valence band of the first hole transport layer 21 is from -1.0 eV to 1.0 eV. In the perovskite solar battery, efficient hole transport depends on good energy level matching between the light absorbing layer/the hole transport layer. In the perovskite solar battery of embodiments of the present application, the whole hole transport layer has an appropriate energy level gradient, and the difference value ΔVBM1 between the top energy level of the valence band of the second hole transport layer and the top energy level of the valence band of the first hole transport layer is from -1.0 eV to 1.0 eV. The second hole transport layer and the first hole transport layer having appropriate difference values of the top energy level of the valence band can effectively reduce the recombination of electrons and holes, and improve the extraction and transport efficiency of holes, to transport more holes to one of the first electrode and the second electrode, thereby further improving the open voltage and current of the perovskite solar battery, and improving the photoelectric conversion efficiency and service life of the perovskite solar battery. A very large difference value between the top energy level of the valence band of the second hole transport layer and the top energy level of the valence band of the first hole transport layer will cause excessive hole transition energy loss between energy levels. For example, in some cases, excess phonons will be generated, thereby not only consuming the electric charge energy, but also affecting the thermal stability of the perovskite solar battery.

In some examples, the difference value ΔVBM1between the top energy level of the valence band of the second hole transport layer 22 and the top energy level of the valence band of the first hole transport layer 21 is -0.8eV-0.8eV, -0.7eV-0.7eV, -0.6eV-0.6eV, -0.5eV-0.5eV, - 0.4eV-0.4eV, or -0.3eV-0.3eV. A smaller difference value between the top energy level of the valence band of the second hole transport layer and the top energy level of the valence band of the first hole transport layer contributes to further reducing the recombination of electrons and holes, improving the hole transport efficiency, and reducing the energy loss.

In some examples, a difference value ΔVBM2 between the top energy level of the valence band of the first hole transport layer 21 and a top energy level of a valence band of the light absorbing layer 3 is from -1.0 eV to 1.0 eV. Optionally, the difference value ΔVBM2 between the top energy level of the valence band of the first hole transport layer 21 and the top energy level of the valence band of the light absorbing layer 3 is -0.8eV-0.8eV, -0.7eV-0.7eV, -0.6eV-0.6eV, - 0.5eV-0.5eV, -0.4eV-0.4eV, or -0.3eV-0.3eV. The difference value between the top energy level of the valence band of the first hole transport layer and the top energy level of the valence band of the light absorbing layer in an appropriate range contributes the first hole transport layer to more efficiently extracting holes in the light absorbing layer.

In some examples, a difference value between a top energy level of a conduction band of the second hole transport layer 22 and a top energy level of a conduction band of the light absorbing layer 3 is greater than or equal to 0.5 eV. The difference value between the top energy level of the conduction band of the second hole transport layer and the top energy level of the conduction band of the light absorbing layer in an appropriate range can block the electron transport, and reduce the recombination of electrons and holes.

In some examples, the difference value between the top energy level of the conduction band of the first hole transport layer 21 and the top energy level of the conduction band of the light absorbing layer 3 is greater than or equal to 0.5 eV. The difference value between the top energy level of the conduction band of the first hole transport layer and the top energy level of the conduction band of the light absorbing layer in an appropriate range can block the electron transport, and reduce the recombination of electrons and holes.

In some examples, a difference value between a Fermi level and the top energy level of the valence band of the second hole transport layer 22 is less than or equal to 1.5 eV. A small difference value between the Fermi level and the top energy level of the valence band of the second hole transport layer can guarantee that the second hole transport layer has better P-type semiconductor properties, and facilitate improving the hole transport capability.

In some examples, a difference value between a Fermi level and the top energy level of the valence band of the first hole transport layer 21 is less than or equal to 1.5 eV. A small difference value between the Fermi level and the top energy level of the valence band of the first hole transport layer can guarantee that the first hole transport layer has better P-type semiconductor properties, and facilitate improving the hole extraction and transport capability.

In some examples, a band gap of the second hole transport layer 22 is greater than or equal to 1.5 eV. The second hole transport layer with a large band gap can better filter ultraviolet light, and reduce the damage of the ultraviolet light to a light absorbing material (e.g., perovskite material).

Thickness of the first hole transport layer 21 is not specifically limited, and may be selected based on actual requirements. In some examples, the thickness of the first hole transport layer 21 is from 5 nm to 1,000 nm. Optionally, the thickness of the first hole transport layer 21 is from 10 nm to 200 nm.

Thickness of the second hole transport layer 22 is not specifically limited, and may be selected based on actual requirements. In some examples, the thickness of the second hole transport layer 22 is from 1 nm to 300 nm. Optionally, the thickness of the second hole transport layer 22 is from 1 nm to 100 nm.

In some examples, a ratio of the thickness of the first hole transport layer 21 to the thickness of the second hole transport layer 22 is from 1:1 to 10:1. Optionally, a ratio of the thickness of the first hole transport layer 21 to the thickness of the second hole transport layer 22 is 1.5:1-10:1, 2:1-10:1, 3:1-10:1, 4:1-10:1, or 5:1-10:1. Compared with the first hole transport layer, the second hole transport layer is thinner, and can form a more compact and more stable film, thereby contributing to improving the hole transport rate.

In some examples, the light absorbing layer 3 comprises a perovskite material. As an intrinsic semiconductor material, the perovskite material not only can transport electrons, but also can transport holes, and therefore, not only can serve as the light absorbing layer, but also can serve as the electron or hole transport layer in the perovskite solar battery.

Types of the perovskite material are not specifically limited, and may be selected based on actual requirements. In some examples, the perovskite material may include one or more of an inorganic halide perovskite material, an organic halide perovskite material, and an organic-inorganic hybrid halide perovskite material. The perovskite material may have a molecular formula of ABX₃, where A represents an inorganic cation, an organic cation, or an organic-inorganic hybrid cation, B represents an inorganic cation, an organic cation, or an organic-inorganic hybrid cation, and X represents an inorganic anion, an organic anion, and an organic-inorganic hybrid anion.

As an example, A is selected from one or more of CH₃NH₃⁺(MA⁺), CH(NH₂)₂⁺(FA⁺), Li⁺, Na⁺, K⁺, Rb⁺, and Cs⁺. Optionally, A is selected from one or more of CH₃NH₃⁺, CH(NH₂)₂⁺, and Cs⁺.

As an example, B is selected from one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺. Optionally, B is selected from one or both of Pb²⁺ and Sn²⁺.

As an example, X is selected from one or more of F⁻, Cl⁻, Br⁻, and I⁻. Optionally, X is selected from one or more of Cl⁻, Br⁻, and I⁻.

In some examples, the perovskite material includes, but is not limited to, one or more of CH₃NH₃PbI₃ (MAPbI₃), CH(NH₂)₂PbI₃ (FAPbI₃), CsPbI₃, CsPbI₂Br, and CsPbIBr₂.

In some examples, thickness of the light absorbing layer 3 is from 50 nm to 2,000 nm.

In some examples, material of the first electrode 1 is not specifically limited, and may be selected based on actual requirements. For example, the material of the first electrode 1 is an organic conductive material, an inorganic conductive material, and an organic-inorganic hybrid conductive material.

In some examples, material of the second electrode 5 is not specifically limited, and may be selected based on actual requirements. For example, the material of the second electrode 5 is an organic conductive material, an inorganic conductive material, and an organic-inorganic hybrid conductive material.

In some examples, one of the first electrode 1 and the second electrode 5 is a transparent electrode. In some examples, both the first electrode 1 and the second electrode 5 are transparent electrodes. Optionally, the transparent electrode is a FTO (flourine-doped tin dioxide, SnO₂:F) electrode, an ITO (indium-doped tin dioxide, SnO₂:In₂O₃) electrode, an AZO (aluminum-doped zinc oxide) electrode, a BZO (boron-doped zinc oxide) electrode, or an IZO (indium zinc oxide) electrode. Optionally, the transparent electrode is an FTO electrode or an ITO electrode.

In some examples, one of the first electrode 1 and the second electrode 5 is a metal electrode or a conductive carbon electrode. Optionally, the metal electrode is selected from one or more of a gold electrode, a silver electrode, an aluminum electrode, and a copper electrode.

In some examples, thickness of the first electrode 1 is not specifically limited, and may be selected based on actual requirements, for example, is from 50 nm to 1,000 nm.

In some examples, thickness of the second electrode 5 is not specifically limited, and may be selected based on actual requirements, for example, is from 10 nm to 500 nm.

As shown in Fig. 1 and Fig. 2, in some examples, the perovskite solar battery further includes an electron transport layer 4. The electron transport layer 4 is located between the light absorbing layer 3 and the second electrode 5 or the first electrode 1, and the light absorbing layer 3 is located between the first hole transport layer 21 and the electron transport layer 4. The electron transport layer can reduce a potential barrier between the electrode and the light absorbing layer, promote the transport of electrons, effectively block holes, and inhibit the recombination of electrons and holes.

In some examples, thickness of the electron transport layer 4 is not specifically limited, and may be selected based on actual requirements, for example, is from 20 nm to 300 nm.

In some examples, an electron transport material of the electron transport layer 4 is not specifically limited, and may be selected based on actual requirements. For example, the electron transport material is selected from an organic electron transport material, an inorganic electron transport material, or an organic-inorganic hybrid electron transport material.

As an example, the electron transport material is selected from at least one of the f ollowing materials: an imide compound, a quinone compound, fullerene and derivatives thereof, 2,2',7,7'-tetrakis(N,N-p-dimethoxyphenylamino)-9,9'-spirobifluorene (Spiro-OMeTAD), methox ytriphenylamine-fluoroformamidine (OMeTPA-FA), poly(3,4-ethylenedioxythiophene): poly(sty renesulfonate) (PEDOT:PSS), poly(3-hexylthiophene) (P3HT), triptycene-cored triphenlamine ( H101), 3,4-ethylenedioxythiophene-methoxytriphenylamine (EDOT-OMeTPA), N-(4-aniline)car bazole-spirobifluorene (CzPAF-SBF), polythiophene, metal oxide (metal element selected from Mg, Ni, Cd, Zn, In, Pb, Mo, W, Sb, Bi, Cu, Hg, Ti, Ag, Mn, Fe, V, Sn, Zr, Sr, Ga, and Cr), silico n oxide (SiO₂), strontium titanate (SrTiO₃), calcium titanate (CaTiO₃), lithium fluoride (LiF), cal cium fluoride (CaF₂), and cuprous thiocyanate (CuSCN).

Optionally, the electron transport material is selected from one or more of fullerenes and derivatives thereof. For example, the electron transport material is selected from one or more of PC₆₀BM and PC₇₀BM. A bottom energy level of a conduction band of fullerenes and derivatives thereof can better match a bottom energy level of the conduction band of the light absorbing layer, thereby promoting electron extraction and transport.

In some examples, the perovskite solar battery includes a first electrode 1, a second hole transport layer 22, a first hole transport layer 21, a light absorbing layer 3, an electron transport layer 4, and a second electrode 5 that are arranged successively. The difference value ΔVBM1 between the top energy level of the valence band of the second hole transport layer 22 and the top energy level of the valence band of the first hole transport layer 21 is from -1.0 eV to 1.0 eV, the first hole transport material of the first hole transport layer 21 is selected from one of PTAA, and nickel oxide that is doped with a first doping element or is undoped, and the second hole transport material of the second hole transport layer 22 includes at least one of: MoO₃, CuI, and NiMgLiO that is doped with the second doping element or is undoped.

In some examples, the perovskite solar battery includes a first electrode 1, an electron transport layer 4, a light absorbing layer 3, a first hole transport layer 21, a second hole transport layer 22, and a second electrode 5 that are arranged successively. The difference value ΔVBM1 between the top energy level of the valence band of the second hole transport layer 22 and the top energy level of the valence band of the first hole transport layer 21 is from -1.0 eV to 1.0 eV, the first hole transport material of the first hole transport layer 21 is selected from one of PTAA, and nickel oxide that is doped with a first doping element or is undoped, and the second hole transport material of the second hole transport layer 22 includes at least one of: MoO₃, CuI, and NiMgLiO that is doped with the second doping element or is undoped.

The perovskite solar battery in the first aspect of embodiments of the present application is not limited to the above structure, and may further include other functional layers. For example, in some examples, the perovskite solar battery further includes a hole blocking layer between the light absorbing layer and the electron transport layer. In some examples, the perovskite solar battery further includes an electrode modifying layer for modifying the first electrode or the second electrode, where the electrode modifying layer can reduce an energy level barrier between the light absorbing layer and the first electrode or the second electrode, to function for transporting holes to block electrons or transporting electrons to block holes.

The perovskite solar battery may be prepared in accordance with a method known in the art. An example preparation method includes the steps of: preparing a first electrode, forming a second hole transport layer on the first electrode, forming a first hole transport layer on the second hole transport layer, forming a light absorbing layer on the first hole transport layer, forming an electron transport layer on the light absorbing layer, and forming a second electrode on the electron transport layer. Another example preparation method includes: preparing a first electrode, forming an electron transport layer on the first electrode, forming a light absorbing layer on the electron transport layer, forming a first hole transport layer on the light absorbing layer, forming a second hole transport layer on the first hole transport layer, and forming a second electrode on the second hole transport layer.

The film-forming method of each of the above film layers is not specifically limited, and a film-forming method known in the art may be used, for example, chemical bath deposition, chemical vapor deposition, electrochemical deposition, physical epitaxis, thermal evaporation, atomic layer deposition, precursor solution slit coating, precursor solution blade coating, sol-gel, magnetron sputtering, and pulsed laser deposition.

An energy band distribution of each film layer may be measured by an X-ray photoelectron spectrometer (XPS) and an ultraviolet photoelectron spectrometer (UPS).

The perovskite solar battery in the first aspect of embodiments of the present application may be used alone as a unijunction perovskite solar battery, or may be combined with a perovskite type or other types of solar batteries to form a stacked solar battery, such as a perovskite-perovskite stacked solar battery or a perovskite-crystalline silicon stacked solar battery.

### Photovoltaic assembly

The second aspect of embodiments of the present application further provides a photovoltaic assembly, the photovoltaic assembly includes the perovskite solar battery in the first aspect of the embodiments of the present application, and the perovskite solar battery may be used as a power source for the photovoltaic assembly after the processes, such as series connection, parallel connection, and encapsulation.

In some examples, the photovoltaic assembly includes a unijunction perovskite solar battery, a perovskite-perovskite stacked solar battery, or a perovskite-crystalline silicon stacked solar battery in the first aspect of the embodiments of the present application.

### Examples

The following examples describe the disclosure of the present application in more detail and are provided for illustrative purposes only, as various modifications and changes within the scope of the disclosure of the present application will be apparent to those skilled in the art. Unless otherwise stated, all parts, percentages, and ratios reported in the following examples are on a weight basis, and all reagents used in the examples are commercially available or can be obtained by synthesis according to conventional methods, and can be directly used without further treatment, and the instruments used in the examples are commercially available. Examples 5, 6, 9 and 10 are Reference Examples.

### Example 1

### Preparation of an ITO electrode:

A group of glass substrates sized 2.0 cm×2.0 cm and covered with ITO were taken, and their surface was successively washed twice with acetone and isopropanol, respectively. Then, they were immersed in deionized water for ultrasonic treatment for 10 min, then dried in an air dry oven, and kept in a glove box (N₂ atmosphere).

### Preparation of a second hole transport layer:

A precursor solution was prepared by adding KCl into a chlorobenzene solution of CuI at a concentration of 0.08 mol/L, where the KCl concentration was 3 g/L, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer:

An aqueous solution of NiOₓ nanocolloid at a concentration of 3 wt% was spin-coated on the obtained second hole transport layer at a speed of 4,000 rpm-6,000 rpm, which was then heated on a thermostatic heating stage at 300 °C for 60 min to obtain the first hole transport layer with a thickness of 15 nm.

### Preparation of a light absorbing layer:

A solution of 1.5 mol/L MAPbI₃ in dimethylformamide was spin-coated on the obtained first hole transport layer at a speed of 3,000 rpm-4,500 rpm, which was then heated on a thermostatic heating stage at 100 °C for 30 min, and cooled to room temperature to obtain the light absorbing layer with a thickness of 800 nm.

### Preparation of an electron transport layer:

A solution of PC₆₀BM in chlorobenzene at a concentration of 20 mg/mL was spin-coated on the obtained light absorbing layer at a speed of 800 rpm-1,500 rpm, which was then heated on a thermostatic heating stage at 100 °C for 10 min to obtain the electron transport layer with a thickness of 60 nm.

### Preparation of an Ag electrode:

The above samples were put into a vacuum coating machine, and an Ag electrode with a thickness of 100 nm was evaporated on the surface of the obtained electron transport layer under the vacuum condition of 5X10⁻⁴ Pa.

The perovskite solar battery finally prepared in Example 1 has a structure of ITO/doped CuI/NiOₓ/MAPbI₃/PC₆₀BM/Ag.

### Example 2

Preparation of an ITO electrode: the same as that in Example 1.

### Preparation of a second hole transport layer:

A precursor solution was prepared by adding KI into an aqueous solution of CuI at a concentration of 0.08 mol/L, where the KI concentration was 3 g/L, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer

A solution of PTAA in toluene at a concentration of 2 mg/mL was spin-coated on the obtained second hole transport layer at a speed of 4,000 rpm-6,000 rpm, which was then heated on a thermostatic heating stage at 100 °C for 10 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Example 2 has a structure of ITO/doped CuI/PTAA/MAPbI₃/PC₆₀BM/Ag.

### Example 3

Preparation of an ITO electrode: the same as that in Example 1.

### Preparation of a second hole transport layer

A precursor solution was prepared by adding KCl into a solution of MoO₃ in chlorobenzene at a concentration of 0.08 mol/L, where the KCl concentration was 3 g/L, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer

An aqueous solution of NiOₓ nanocolloid at a concentration of 3 wt% was spin-coated on the obtained second hole transport layer at a speed of 4,000 rpm-6,000 rpm, which was then heated on a thermostatic heating stage at 300 °C for 60 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Example 3 has a structure of ITO/doped MoO₃/NiOₓ/MAPbI₃/PC₆₀BM/Ag.

### Example 4

Preparation of an ITO electrode: the same as that in Example 1.

### Preparation of a second hole transport layer:

A precursor solution was prepared by adding KCl into an aqueous solution of MoO₃ colloid at a concentration of 0.08 mol/L, where the KCl concentration was 3 g/L, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer

A solution of PTAA in toluene at a concentration of 2 mg/mL was spin-coated on the obtained second hole transport layer at a speed of 4,000 rpm-6,000 rpm, which was then heated on a thermostatic heating stage at 100 °C for 10 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Example 4 has a structure of ITO/doped MoO₃/PTAA/MAPbI₃/PC₆₀BM/Ag.

### Reference Example 5 (not according to the invention)

Preparation of an ITO electrode: the same as that in Example 1.

### Preparation of a second hole transport layer

A precursor solution was prepared by adding KCl into a solution of NiMgLiO in chlorobenzene at a concentration of 0.08 mol/L, where the KCl concentration was 3 g/L, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer

An aqueous solution of NiOₓ nanocolloid at a concentration of 3 wt% was spin-coated on the obtained second hole transport layer at a speed of 4,000 rpm-6,000 rpm, which was then heated on a thermostatic heating stage at 300 °C for 60 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Reference Example 5 has a structure of ITO/doped NiMgLiO/NiOₓ/MAPbI₃/PC₆₀BM/Ag.

### Reference Example 6 (not according to the invention)

Preparation of an ITO electrode: the same as that in Example 1.

### Preparation of a second hole transport layer:

A precursor solution was prepared by adding KCl into an aqueous solution of NiMgLiO colloid at a concentration of 0.08 mol/L, where the KCl concentration was 3 g/L, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer:

A solution of PTAA in toluene at a concentration of 2 mg/mL was spin-coated on the obtained second hole transport layer at a speed of 4,000 rpm-6,000 rpm, which was then heated on a thermostatic heating stage at 100 °C for 10 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Reference Example 6 has a structure of ITO/doped NiMgLiO/PTAA/MAPbI₃/PC₆₀BM/Ag.

### Example 7

Preparation of an ITO electrode: the same as that in Example 1.

### Preparation of a second hole transport layer:

A precursor solution was prepared by adding lithium carbonate into an aqueous solution of MoO₃ colloid at a concentration of 0.08 mol/L, where the lithium carbonate concentration was 10%, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer:

A solution of PTAA in toluene at a concentration of 2 mg/mL was spin-coated on the obtained second hole transport layer at a speed of 4,000 rpm-6,000 rpm, which was then heated on a thermostatic heating stage at 100 °C for 10 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Example 7 has a structure of ITO/doped MoO₃/PTAA/MAPbI₃/PC₆₀BM/Ag.

### Example 8

Preparation of an ITO electrode: the same as that in Example 1.

### Preparation of a second hole transport layer:

A precursor solution was prepared by adding lithium carbonate into an aqueous solution of MoO₃ colloid at a concentration of 0.08 mol/L, where the lithium carbonate concentration was 6%, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer:

An aqueous solution of NiOₓ nanocolloid at a concentration of 3 wt% was spin-coated on the obtained second hole transport layer at a speed of 4,000 rpm-6,000 rpm, which was then heated on a thermostatic heating stage at 300 °C for 60 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Example 8 has a structure of ITO/doped MoO₃/NiOₓ/MAPbI₃/PC₆₀BM/Ag.

### Reference Example 9 (not according to the invention)

Preparation of an ITO electrode: the same as that in Example 1.

### Preparation of a second hole transport layer:

A precursor solution was prepared by adding CoCl₂ into an aqueous solution of Cu₂O colloid at a concentration of 0.08 mol/L, where the CoCl₂ concentration was 10%, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer:

A solution of PTAA in toluene at a concentration of 2 mg/mL was spin-coated on the obtained second hole transport layer at a speed of 4,000 rpm-6,000 rpm, which was then heated on a thermostatic heating stage at 100 °C for 10 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Reference Example 9 has a structure of ITO/doped Cu₂O/PTAA/MAPbI₃/PC₆₀BM/Ag.

### Reference Example 10 (not according to the invention)

Preparation of an ITO electrode: the same as that in Example 1.

### Preparation of a second hole transport layer:

A precursor solution was prepared by adding CoCl₂ into an aqueous solution of Cu₂O colloid at a concentration of 0.08 mol/L, where the CoCl₂ concentration was 20%, and the precursor solution was spin-coated on the obtained ITO glass substrate at a speed of 5,000 rpm-6,500 rpm, which was then heated on a thermostatic heating stage at 300 °C for 15 min to obtain the second hole transport layer with a thickness of 10 nm.

### Preparation of a first hole transport layer:

An aqueous solution of NiOₓ nanocolloid at a concentration of 3 wt% was spin-coated on the obtained second hole transport layer at a speed of 4,000 rpm-6,000 rpm, which was then heated on a thermostatic heating stage at 300 °C for 60 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Reference Example 10 has a structure of ITO/doped Cu₂O/NiOₓ/MAPbI₃/PC₆₀BM/Ag.

### Comparative Example 1

Preparation of an ITO electrode: the same as that in Example 1.

### Preparation of a hole transport layer

A hybrid solution of NiOₓ-CuI in chlorobenzene at a concentration of 6 wt% was spin-coated on the obtained ITO glass substrate at a speed of 4,000 rpm-6,000 rpm, where a mass ratio of nickel oxide to CuI was 1:1, which was then heated on a thermostatic heating stage at 300 °C for 60 min to obtain the hole transport layer with a thickness of 25 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Comparative Example 1 has a structure of ITO/NiOₓ+CuI/MAPbI₃/PC₆₀BM/Ag.

### Comparative Example 2

Preparation of an ITO electrode: the same as that in Example 1.

### Preparation of a hole transport layer:

A hybrid solution of PTAA-CuI in chlorobenzene at a concentration of 2 mg/mL was spin-coated on the obtained ITO glass substrate at a speed of 4,000 rpm-6,000 rpm, where a mass ratio of PTAA to CuI was 1:1, which was then heated on a thermostatic heating stage at 100 °C for 15 min to obtain the hole transport layer with a thickness of 25 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Comparative Example 2 has a structure of ITO/PTAA+CuI/MAPbI₃/PC₆₀BM/Ag.

### Comparative Example 3

Preparation of an ITO electrode: the same as that in Example 1.

### Preparation of a second hole transport layer:

A solution of tri(isopropoxy)vanadium oxide in isopropanol was spin-coated on the obtained ITO glass substrate at a speed of 5,000 rpm-6,500 rpm, which was then heated on a thermostatic heating stage at 120 °C for 15 min to obtain the second hole transport layer with a thickness of 10 nm.

### Preparation of a first hole transport layer:

An aqueous solution of NiOₓ nanocolloid at a concentration of 3 wt% was spin-coated on the obtained second hole transport layer at a speed of 4,000 rpm-6,000 rpm, which was then heated on a thermostatic heating stage at 300 °C for 60 min to obtain the first hole transport layer with a thickness of 15 nm.

Preparation of a light absorbing layer: the same as that in Example 1.

Preparation of an electron transport layer: the same as that in Example 1.

Preparation of an Ag electrode: the same as that in Example 1.

The perovskite solar battery finally prepared in Comparative Example 3 has a structure of ITO/V₂O₅/NiOₓ/MAPbI₃/PC₆₀BM/Ag.

### Test

Energy band distributions of the obtained hole transport layer and light absorbing layer were measured using an X-ray photoelectron spectrometer (XPS) model Escalab 250Xi (from Thermo Scientific) at room temperature under normal pressure. The results are shown in Table 1.

Table 2 shows the test results of open-circuit voltages Voc, short-circuit current density Jsc, fill factors, and power conversion efficiency of the perovskite solar batteries prepared in Examples 1-10 and Comparative Examples 1-3 under standard simulated sunlight illumination (AM1.5G).

**Table 1**

| No. | First hole transport layer | | Second hole transport layer | | ΔVBM1 (eV) | Light absorbing layer: | | ΔVBM2 (eV) |
|---|---|---|---|---|---|---|---|---|
| | VBM (eV) | CBM (eV) | VBM (eV) | CBM (eV) | | VBM (eV) | CBM (eV) | |
| Example 1 | -5.3 | -1.8 | -5.2 | -2.1 | 0.1 | -5.4 | -4.0 | 0.1 |
| Example 2 | -5.2 | -1.8 | -5.1 | -2.0 | 0.1 | -5.4 | -4.0 | 0.2 |
| Example 3 | -5.3 | -1.8 | -5.2 | -2.1 | 0.1 | -5.4 | -4.0 | 0.1 |
| Example 4 | -5.2 | -1.8 | -5.2 | -2.1 | 0 | -5.4 | -4.0 | 0.2 |
| Reference Example 5 | -5.3 | -1.8 | -5.15 | -1.3 | 0.15 | -5.4 | -4.0 | 0.1 |
| Reference Example 6 | -5.2 | -1.8 | -5.15 | -1.3 | 0.05 | -5.4 | -4.0 | 0.2 |
| Example 7 | -5.2 | -1.8 | -6.2 | -3.2 | -1.0 | -5.4 | -4.0 | 0.2 |
| Example 8 | -5.3 | -1.8 | -5.6 | -2.6 | -0.3 | -5.4 | -4.0 | 0.1 |
| Reference Example 9 | -5.2 | -1.8 | -4.9 | -2.1 | 0.3 | -5.4 | -4.0 | 0.2 |
| Reference Example 10 | -5.3 | -1.8 | -4.3 | -1.5 | 1.0 | -5.4 | -4.0 | 0.1 |
| Comparative Example 1 | -5.0 | -3.2 | - | - | - | -5.4 | -4.0 | 0.4 |
| Comparative Example 2 | -4.9 | -3.5 | - | - | - | -5.4 | -4.0 | 0.5 |
| Comparative Example 3 | -5.3 | -1.8 | -5.2 | -2.4 | 0.1 | -5.4 | -4.0 | 0.1 |

**Table 2**

| No. | Voc (V) | Jsc (mA/cm²) | Fill Factor (%) | Efficiency (%) |
|---|---|---|---|---|
| Example 1 | 1.15 | 23.6 | 75.5 | 20.5 |
| Example 2 | 1.13 | 23.4 | 75.6 | 20.0 |
| Example 3 | 1.14 | 23.5 | 75.8 | 20.3 |
| Example 4 | 1.08 | 23.2 | 75.8 | 19.0 |
| Reference Example 5 | 1.12 | 23.4 | 75.5 | 19.8 |
| Reference Example 6 | 1.10 | 23.4 | 75.8 | 19.5 |
| Example 7 | 1.02 | 20.7 | 70.5 | 14.9 |
| Example 8 | 1.05 | 20.4 | 72.3 | 15.5 |
| Reference Example 9 | 1.06 | 20.8 | 72.5 | 16.0 |
| Reference Example 10 | 1.04 | 20.5 | 71.2 | 15.2 |
| Comparative Example 1 | 0.95 | 20.0 | 57.9 | 11.0 |
| Comparative Example 2 | 0.93 | 19.0 | 59.4 | 10.5 |
| Comparative Example 3 | 0.98 | 19.8 | 58.1 | 11.3 |

As can be seen from the test results in Table 2, the perovskite solar batteries prepared in Examples 1-10 have higher open-circuit voltages Voc, short-circuit current density Jsc, filling factors, and power conversion efficiency than the perovskite solar batteries prepared in Comparative Example 1 and Comparative Example 2.

As can be further seen from the test results in Table 2, in reference document 3, V₂O₅ is used as the second hole transport material, but the resulting perovskite solar battery has poorer performance than the perovskite solar batteries prepared in Examples 1-10. The possible reason is that V₂O₅ is slightly soluble in water at room temperature and has certain hygroscopicity; in addition, V₂O₅ is a strong oxidant, and is very easily consumed by a reductant in the environment when it is not encapsulated, thus forming a powder or mesoporous state, additionally introducing water and oxygen in the environment into the perovskite solar battery, and failing to favorably isolating water and oxygen. In addition, the lattice matching between V₂O₅ and nickel oxide is not ideal, and the first hole transport layer is poorly protected and passivated. Therefore, there is high interface impedance and defect density between the first hole transport layer and the second hole transport layer, thereby affecting the hole extraction and transport.

While the above description merely provides specific embodiments of the present application, the scope of protection of the present application is not limited to the specific embodiments. The scope of the present application shall be determined with reference to the scope of the claims.

## Claims

1. A perovskite solar battery, comprising:
a first electrode (1);
a second electrode (5); and
a light absorbing layer (3) between the first electrode (1) and the second electrode (5),
wherein
the perovskite solar battery further comprises a first hole transport layer (21) and a second hole transport layer (22), the first hole transport layer (21) being located between the second hole transport layer (22) and the light absorbing layer (3), wherein the second hole transport layer (22) is located between the first electrode (1) and the light absorbing layer (3), or the second hole transport layer (22) is located between the second electrode (5) and the light absorbing layer (3),
a first hole transport material of the first hole transport layer (21) is selected from one of poly-[bis-(4-phenyl)(2,4,6-trimethylphenyl)-amine] (PTAA), and nickel oxide that is doped with a first doping element or is undoped, and
a second hole transport material of the second hole transport layer (22) includes at least one of a P-type transition metal oxide semiconductor material and a P-type transition metal halide semiconductor material capable of isolating water and oxygen;
**characterized in that**
the second hole transport material is doped with a second doping element, wherein the second hole transport material includes at least one material selected from: MoO₃, CuO, Cu₂O, CuI, CuGaO₂, CuCrO₂, and CoO; and
the second doping element may be in the form of atoms, molecules or ions and includes at least one of an alkali metal element, a post-transition metal element, a metalloid element, a halogen element, a nonmetallic element, an ionic liquid, a carboxylic acid, phosphoric acid, a carbon derivative, a self-assembled monomolecule, and a polymer;
wherein in the second doping element,
the alkali metal element includes at least one of Li, Na, K, Rb, and Cs,
the post-transition metal element includes at least one of Al, Ga, In, Sn, Tl, Pb, and Bi,
the metalloid element includes at least one of B, Si, Ge, As, Sb, and Te,
the halogen element includes at least one of F, Cl, Br, and I,
the nonmetallic element includes at least one of P, S, and Se,
the ionic liquid includes at least one of 1-butyl-3-methylimidazolium tetrafluoroborate, NH₄Cl, (NH₄)₂S, tetramethylammonium hydroxide aqueous solution, and trifluoroethanol,
the carboxylic acid includes at least one of ethylenediaminetetraacetic acid, diethylenetriaminepentaacetic acid, 4-imidazoleacetic acid hydrochloride, and acetic acid,
the carbon derivative includes at least one of carbon quantum dot, carbon nanotube, graphene, C₆₀, g-C₃N₄, C₉, NPC₆₀-OH, and DPC₆₀,
the self-assembled monomolecule includes at least one of 2-phenethylamine hydroiodide, N,N-diethylaniline, 9,9-bis(4-aminophenyl)fluorene, 4-picolinic acid, dopamine, 3-aminopropyltriethoxysilane, and glycine, and
the polymer includes at least one of styrene, polyethyleneimine, polyethylene oxide, and tris(N,N-tetramethylene)phosphoric acid triamide.

2. The perovskite solar battery according to claim 1, wherein a difference value ΔVBM1 between a top energy level of a valence band of the second hole transport layer (22) and a top energy level of a valence band of the first hole transport layer (21) is from -1.0 eV to 1.0 eV, and optionally from -0.3 eV to 0.3 eV; wherein the energy levels are determined by an X-ray photoelectron spectrometer or an ultraviolet photoelectron spectrometer as outlined in the description.

3. The perovskite solar battery according to claim 1 or 2, wherein the first doping element includes at least one of an alkali metal element, an alkali earth metal element, a transition metal element, and a halogen element, wherein
optionally, the alkali metal element includes at least one of Li, Na, K, Rb, and Cs,
optionally, the alkali earth metal element includes at least one of Be, Mg, Ca, Sr, and Ba,
optionally, the transition metal element includes at least one of Ti, Cr, Mn, Fe, Co, Ni, Cu, Zn, Zr, Nb, Mo, Ru, Rh, Pd, Ag, Cd, Ta, Pt, and Au, and
optionally, the halogen element includes at least one of F, Cl, Br, and I.

4. The perovskite solar battery according to any one of claims 1 to 3, wherein, based on a total mass of the first hole transport material, a percentage mass content of the first doping element is less than or equal to 20 %, and optionally from 5% to 15%.

5. The perovskite solar battery according to any one of claims 1 to 4, wherein, based on a total mass of the second hole transport material, a percentage mass content of the second doping element is less than or equal to 30 %, and optionally from 5% to 25%.

6. The perovskite solar battery according to any one of claims 1 to 5, wherein a difference value ΔVBM2 between a top energy level of a valence band of the first hole transport layer (21) and a top energy level of a valence band of the light absorbing layer (3) is from -1.0 eV to 1.0 eV, and optionally from -0.3 eV to 0.3 eV; wherein the energy levels are determined by an X-ray photoelectron spectrometer or an ultraviolet photoelectron spectrometer as outlined in the description.

7. The perovskite solar battery according to any one of claims 1 to 6, wherein
a difference value between a top energy level of a conduction band of the second hole transport layer (22) and a top energy level of a conduction band of the light absorbing layer (3) is greater than or equal to 0.5 eV, and/or
a difference value between a top energy level of a conduction band of the first hole transport layer (21) and a top energy level of a conduction band of the light absorbing layer (3) is greater than or equal to 0.5 eV;
wherein the energy levels are determined by an X-ray photoelectron spectrometer or an ultraviolet photoelectron spectrometer as outlined in the description.

8. The perovskite solar battery according to any one of claims 1 to 7, wherein a difference value between a Fermi level and the top energy level of the valence band of the second hole transport layer (22) is less than or equal to 1.5 eV, and/or
a difference value between a Fermi level and the top energy level of the valence band of the first hole transport layer (21) is less than or equal to 1.5 eV;
and/or
wherein a band gap of the second hole transport layer (22) is greater than or equal to 1.5 eV;
wherein the energy levels are determined by an X-ray photoelectron spectrometer or an ultraviolet photoelectron spectrometer as outlined in the description.

9. The perovskite solar battery according to any one of claims 1 to 8, wherein
the thickness of the second hole transport layer (22) is from 1 nm to 300 nm, and optionally 1 nm to 100 nm, and/or
the thickness of the first hole transport layer (21) is from 5 nm to 1,000 nm, and optionally from 10 nm to 200 nm, and
optionally, a ratio of the thickness of the first hole transport layer (21) to the thickness of the second hole transport layer (22) is from 1:1 to 10:1.

10. The perovskite solar battery according to any one of claims 1 to 9, wherein one of the first electrode (1) and the second electrode (5) is a transparent electrode, and optionally, the transparent electrode is an FTO electrode or an ITO electrode.

11. The perovskite solar battery according to any one of claims 1 to 10, wherein one of the first electrode (1) and the second electrode (5) is a metal electrode or a conductive carbon electrode, and optionally, the metal electrode is selected from one or more of a gold electrode, a silver electrode, an aluminum electrode, and a copper electrode.

12. The perovskite solar battery according to any one of claims 1 to 11, wherein the perovskite solar battery further comprises an electron transport layer (4), the electron transport layer (4) is located between the light absorbing layer (3) and the second electrode (5) or the first electrode (1), and the light absorbing layer (3) is located between the first hole transport layer (21) and the electron transport layer (4).

13. A photovoltaic assembly, comprising the perovskite solar battery according to any one of claims 1 to 12.

## Patentansprüche

1. Perowskit-Solarbatterie, Folgendes umfassend:
eine erste Elektrode (1);
eine zweite Elektrode (5); und
eine lichtabsorbierende Schicht (3) zwischen der ersten Elektrode (1) und der zweiten Elektrode (5), wobei
die Perowskit-Solarbatterie weiterhin eine erste Lochtransportschicht (21) und eine zweite Lochtransportschicht (22) umfasst, wobei die erste Lochtransportschicht (21) zwischen der zweiten Lochtransportschicht (22) und der lichtabsorbierenden Schicht (3) angeordnet ist, wobei die zweite Lochtransportschicht (22) zwischen der ersten Elektrode (1) und der lichtabsorbierenden Schicht (3) angeordnet ist oder die zweite Lochtransportschicht (22) zwischen der zweiten Elektrode (5) und der lichtabsorbierenden Schicht (3) angeordnet ist,
ein erstes Lochtransportmaterial der ersten Lochtransportschicht (21) ausgewählt ist aus der Gruppe, bestehend aus Poly-Bis-4-phenyl-2,4,6-trimethylphenylamin (PTAA) und Nickeloxid, das mit einem ersten Dotierungselement dotiert ist oder undotiert ist, und
ein zweites Lochtransportmaterial der zweiten Lochtransportschicht (22) mindestens ein Material umfasst aus p-leitendem Übergangsmetalloxid-Halbleitermaterial und p-leitendem Übergangsmetallhalogenid-Halbleitermaterial, die Wasser und Sauerstoff isolieren können;
**dadurch gekennzeichnet, dass**
das zweite Lochtransportmaterial mit einem zweiten Dotierungselement dotiert ist, wobei das zweite Lochtransportmaterial mindestens ein Material umfasst, ausgewählt aus: MoO₃, CuO, CU₂O, CuI, CuGaO₂, CuCrO₂ und CoO; und
das zweite Dotierungselement in Form von Atomen, Molekülen oder Ionen vorliegen kann und mindestens eines von einem Alkalimetall-Element, einem Post-Übergangsmetall-Element, einem Metalloid-Element, einem Halogen-Element, einem nichtmetallischen Element, einer ionischen Flüssigkeit, einer Carbonsäure, einer Phosphorsäure, einem Kohlenstoff-Derivat, einem selbstorganisierenden Monomolekül und einem Polymer umfasst;
wobei in dem zweiten Dotierungselement
das Alkalimetall-Element mindestens eines von Li, Na, K, Rb und Cs umfasst,
das Post-Übergangsmetall-Element mindestens eines von Al, Ga, In, Sn, Tl, Pb und Bi umfasst,
das Metalloid-Element mindestens eines von B, Si, Ge, As, Sb und Te umfasst,
das Halogen-Element mindestens eines von F, Cl, Br und I umfasst,
das nichtmetallische Element mindestens eines von P, S und Se umfasst,
die ionische Flüssigkeit mindestens eine von 1-Butyl-3-methylimidazoliumtetrafluorborat, NH₄Cl, (NH₄)₂S, wässriger Tetramethylammoniumhydroxid-Lösung und Trifluorethanol umfasst,
die Carbonsäure mindestens eine von Ethylendiamintetraessigsäure, Diethylentriaminpentaessigsäure, 4-Imidazolessigsäurehydrochlorid und Essigsäure umfasst,
das Kohlenstoff-Derivat mindestens eines von Kohlenstoff-Quantenpunkten, Kohlenstoff-Nanoröhrchen, Graphen, C₆₀, g-C₃N₄, C₉, NPC₆₀-OH und DPC₆₀ umfasst,
das selbstorganisierende Monomolekül mindestens eines von 2-Phenethylaminhydroiodid, N,N-Diethylanilin, 9,9-Bis-4-aminophenylfluoren, 4-Picolinsäure, Dopamin, 3-Aminopropyltriethoxysilan und Glycin umfasst und
das Polymer mindestens eines von Styrol, Polyethylenimin, Polyethylenoxid und Tris-N,N-tetramethylenphosphorsäuretriamid umfasst.

2. Perowskit-Solarbatterie nach Anspruch 1, wobei ein Differenzwert ΔVBM1 zwischen einem oberen Energieniveau eines Valenzbands der zweiten Lochtransportschicht (22) und einem oberen Energieniveau eines Valenzbands der ersten Lochtransportschicht (21) von -1,0 eV bis 1,0 eV und gegebenenfalls von -0,3 eV bis 0,3 eV beträgt; wobei die Energieniveaus durch ein Röntgen-Photoelektronenspektrometer oder ein Ultraviolett-Photoelektronenspektrometer bestimmt werden, wie in der Beschreibung umrissen.

3. Perowskit-Solarbatterie nach Anspruch 1 oder 2, wobei das erste Dotierungselement mindestens eines von einem Alkalimetall-Element, einem Erdalkalimetall-Element, einem Übergangsmetall-Element und einem Halogen-Element umfasst, wobei
gegebenenfalls das Alkalimetall-Element mindestens eines von Li, Na, K, Rb und Cs umfasst,
gegebenenfalls das Erdalkalimetall-Element mindestens eines von Be, Mg, Ca, Sr und Ba umfasst,
gegebenenfalls das Übergangsmetall-Element mindestens eines von Ti, Cr, Mn, Fe, Co, Ni, Cu, Zn, Zr, Nb, Mo, Ru, Rh, Pd, Ag, Cd, Ta, Pt und Au umfasst und
gegebenenfalls das Halogen-Element mindestens eines von F, Cl, Br und I umfasst.

4. Perowskit-Solarbatterie nach einem der Ansprüche 1 bis 3, wobei, auf Grundlage einer Gesamtmasse des ersten Lochtransportmaterials, ein prozentualer Massegehalt des ersten Dotierungselements kleiner oder gleich 20 % und gegebenenfalls zwischen 5 % und 15 % ist.

5. Perowskit-Solarbatterie nach einem der Ansprüche 1 bis 4, wobei, auf Grundlage einer Gesamtmasse des zweiten Lochtransportmaterials, ein prozentualer Massegehalt des zweiten Dotierungselements kleiner oder gleich 30 % und gegebenenfalls zwischen 5 % und 25 % ist.

6. Perowskit-Solarbatterie nach einem der Ansprüche 1 bis 5, wobei ein Differenzwert ΔVBM2 zwischen einem oberen Energieniveau eines Valenzbands der ersten Lochtransportschicht (21) und einem oberen Energieniveau eines Valenzbands der lichtabsorbierenden Schicht (3) zwischen -1,0 eV und 1,0 eV beträgt,
und gegebenenfalls zwischen -0,3 eV und 0,3 eV; wobei die Energieniveaus durch ein Röntgen-Photoelektronenspektrometer oder ein Ultraviolett-Photoelektronenspektrometer bestimmt werden, wie in der Beschreibung umrissen.

7. Perowskit-Solarbatterie nach einem der Ansprüche 1 bis 6, wobei
ein Differenzwert zwischen einem oberen Energieniveau eines Leitungsbands der zweiten Lochtransportschicht (22) und einem oberen Energieniveau eines Leitungsbands der lichtabsorbierenden Schicht (3) größer oder gleich 0,5 eV ist und/oder
ein Differenzwert zwischen einem oberen Energieniveau eines Leitungsbands der ersten Lochtransportschicht (21) und einem oberen Energieniveau eines Leitungsbands der lichtabsorbierenden Schicht (3) größer oder gleich 0,5 eV ist;
wobei die Energieniveaus durch ein Röntgen-Photoelektronenspektrometer oder ein Ultraviolett-Photoelektronenspektrometer bestimmt werden, wie in der Beschreibung umrissen.

8. Perowskit-Solarbatterie nach einem der Ansprüche 1 bis 7, wobei ein Differenzwert zwischen einem Fermi-Niveau und dem oberen Energieniveau des Valenzbands der zweiten Lochtransportschicht (22) kleiner oder gleich 1,5 eV ist und/oder
ein Differenzwert zwischen einem Fermi-Niveau und dem oberen Energieniveau des Valenzbands der ersten Lochtransportschicht (21) kleiner oder gleich 1,5 eV ist;
und/oder
wobei eine Bandlücke der zweiten Lochtransportschicht (22) größer oder gleich 1,5 eV ist;
wobei die Energieniveaus durch ein Röntgen-Photoelektronenspektrometer oder ein Ultraviolett-Photoelektronenspektrometer bestimmt werden, wie in der Beschreibung umrissen.

9. Perowskit-Solarbatterie nach einem der Ansprüche 1 bis 8, wobei
die Dicke der zweiten Lochtransportschicht (22) von 1 nm bis 300 nm und gegebenenfalls von 1 nm bis 100 nm beträgt und/oder
die Dicke der ersten Lochtransportschicht (21) von 5 nm bis 1.000 nm und gegebenenfalls von 10 nm bis 200 nm beträgt und
gegebenenfalls ein Verhältnis der Dicke der ersten Lochtransportschicht (21) zu der Dicke der zweiten Lochtransportschicht (22) zwischen 1:1 und 10:1 ist.

10. Perowskit-Solarbatterie nach einem der Ansprüche 1 bis 9, wobei die erste Elektrode (1) oder die zweite Elektrode (5) eine transparente Elektrode ist und gegebenenfalls die transparente Elektrode eine FTO-Elektrode oder eine ITO-Elektrode ist.

11. Perowskit-Solarbatterie nach einem der Ansprüche 1 bis 10, wobei die erste Elektrode (1) oder die zweite Elektrode (5) eine Metallelektrode oder eine leitfähige Kohlenstoff-Elektrode ist und gegebenenfalls die Metallelektrode ausgewählt ist aus mindestens einer von einer Gold-Elektrode, einer Silber-Elektrode, einer Aluminium-Elektrode und einer Kupfer-Elektrode.

12. Perowskit-Solarbatterie nach einem der Ansprüche 1 bis 11, wobei die Perowskit-Solarbatterie weiterhin eine Elektronentransportschicht (4) umfasst, die Elektronentransportschicht (4) zwischen der lichtabsorbierenden Schicht (3) und der zweiten Elektrode (5) oder der ersten Elektrode (1) angeordnet ist und die lichtabsorbierende Schicht (3) zwischen der ersten Lochtransportschicht (21) und der Elektronentransportschicht (4) angeordnet ist.

13. Photovoltaik-Anlage, die Perowskit-Solarbatterie nach einem der Ansprüche 1 bis 12 umfassend.

## Revendications

1. Batterie solaire en pérovskite, comprenant :
une première électrode (1) ;
une seconde électrode (5) ; et
une couche d'absorption de lumière (3) entre la première électrode (1) et la seconde électrode (5),
dans laquelle
la batterie solaire en pérovskite comprend en outre une première couche de transport de trous (21) et une seconde couche de transport de trous (22), la première couche de transport de trous (21) étant située entre la seconde couche de transport de trous (22) et la couche d'absorption de lumière (3), dans laquelle la seconde couche de transport de trous (22) est située entre la première électrode (1) et la couche d'absorption de lumière (3), ou la seconde couche de transport de trous (22) est située entre la seconde électrode (5) et la couche d'absorption de lumière (3),
un premier matériau de transport de trous de la première couche de transport de trous (21) est sélectionné parmi un matériau parmi du poly-[bis-(4-phényl)(2,4,6-triméthylphényl)-amine] (PTAA), et de l'oxyde de nickel qui est dopé avec un premier élément dopant ou est non dopé, et un second matériau de transport de trous de la seconde couche de transport de trous (22) inclut au moins un matériau parmi un matériau semi-conducteur d'oxyde de métal de transition de type P et un matériau semi-conducteur d'halogénure de métal de transition de type P capable d'isoler l'eau et l'oxygène ;
**caractérisée en ce que**
le second matériau de transport de trous est dopé avec un second élément dopant, dans laquelle le second matériau de transport de trous inclut au moins un matériau sélectionné parmi : MoO₃, CuO, Cu₂O, CuI, CuGaO₂, CuCrO₂, et CoO ; et
le second élément dopant peut être sous la forme d'atomes, de molécules ou d'ions et inclut au moins un élément parmi un élément de métal alcalin, un élément de métal de post-transition, un élément métalloïde, un élément halogène, un élément non métallique, un liquide ionique, un acide carboxylique, de l'acide phosphorique, un dérivé du carbone, une monomolécule auto-assemblée et un polymère ;
dans laquelle dans le second élément dopant,
l'élément de métal alcalin inclut au moins un élément parmi Li, Na, K, Rb, et Cs,
l'élément de métal de post-transition inclut au moins un élément parmi Al, Ga, In, Sn, Tl, Pb, et Bi,
l'élément métalloïde inclut au moins un élément parmi B, Si, Ge, As, Sb, et Te,
l'élément halogène inclut au moins un élément parmi F, Cl, Br, et I,
l'élément non métallique inclut au moins un élément parmi P, S, et Se,
le liquide ionique inclut au moins un élément parmi le tétrafluoroborate de 1-butyl-3-méthylimidazolium, NH₄Cl, (NH₄)₂S, une solution aqueuse d'hydroxyde de tétraméthylammonium, et le trifluoro-éthanol,
l'acide carboxylique inclut au moins un élément parmi l'acide éthylènediaminetétra-acétique, l'acide diéthylènetriaminepenta-acétique, le chlorhydrate d'acide 4-imidazoleacétique, et l'acide acétique,
le dérivé du carbone inclut au moins un élément parmi le point quantique de carbone, le nanotube de carbone, le graphène, C₆₀, g-C₃N₄, C₉, NPC₆₀-OH, et DPC₆₀,
la monomolécule auto-assemblée inclut au moins un élément parmi l'hydro-iodure de 2-phénéthylamine, la N,N-diéthylaniline, le 9,9-bis(4-aminophényl)fluorène, l'acide 4-picolinique, la dopamine, le 3-aminopropyltriéthoxysilane, et la glycine, et
le polymère inclut au moins un élément parmi le styrène, la polyéthylène-imine, l'oxyde de polyéthylène, et le triamide d'acide tris(N, N-tétraméthylène)phosphorique.

2. Batterie solaire en pérovskite selon la revendication 1, dans laquelle une valeur de différence ΔVBM1entre un niveau d'énergie maximum d'une bande de valence de la seconde couche de transport de trous (22) et un niveau d'énergie maximum d'une bande de valence de la première couche de transport de trous (21) est de -1,0 eV à 1,0 eV, et facultativement de -0,3 eV à 0,3 eV ; dans laquelle les niveaux d'énergie sont déterminés par un spectromètre photo-électronique à rayons X ou un spectromètre photo-électronique ultraviolet comme exposé dans la description.

3. Batterie solaire en pérovskite selon la revendication 1 ou la revendication 2, dans laquelle le premier élément dopant inclut au moins un élément parmi un élément de métal alcalin, un élément de métal alcalino-terreux, un élément de métal de transition, et un élément halogène, dans laquelle
facultativement, l'élément de métal alcalin inclut au moins un élément parmi Li, Na, K, Rb, et Cs,
facultativement, l'élément de métal alcalino-terreux inclut au moins un élément parmi Be, Mg, Ca, Sr, et Ba,
facultativement, l'élément de métal de transition inclut au moins un élément parmi Ti, Cr, Mn, Fe, Co, Ni, Cu, Zn, Zr, Nb, Mo, Ru, Rh, Pd, Ag, Cd, Ta, Pt, et Au, et
facultativement, l'élément halogène inclut au moins un élément parmi F, Cl, Br, et I.

4. Batterie solaire en pérovskite selon l'une quelconque des revendications 1 à 3, dans laquelle, sur la base d'une masse totale du premier matériau de transport de trous, une teneur en masse en pourcentage du premier élément dopant est inférieure ou égale à 20 %, et facultativement de 5 % à 15 %.

5. Batterie solaire en pérovskite selon l'une quelconque des revendications 1 à 4, dans laquelle, sur la base d'une masse totale du second matériau de transport de trous, une teneur en masse en pourcentage du second élément dopant est inférieure ou égale à 30 %, et facultativement de 5 % à 25 %.

6. Batterie solaire en pérovskite selon l'une quelconque des revendications 1 à 5, dans laquelle une valeur de différence ΔVBM2 entre un niveau d'énergie maximum d'une bande de valence de la première couche de transport de trous (21) et un niveau d'énergie maximum d'une bande de valence de la couche d'absorption de lumière (3) est de -1,0 eV à 1,0 eV, et facultativement de -0,3 eV à 0,3 eV ; dans laquelle les niveaux d'énergie sont déterminés par un spectromètre photo-électronique à rayons X ou un spectromètre photo-électronique ultraviolet comme exposé dans la description.

7. Batterie solaire en pérovskite selon l'une quelconque des revendications 1 à 6, dans laquelle
une valeur de différence entre un niveau d'énergie maximum d'une bande de conduction de la seconde couche de transport de trous (22) et un niveau d'énergie maximum d'une bande de conduction de la couche d'absorption de lumière (3) est supérieure ou égale à 0,5 eV, et/ou
une valeur de différence entre un niveau d'énergie maximum d'une bande de conduction de la première couche de transport de trous (21) et un niveau d'énergie maximum d'une bande de conduction de la couche d'absorption de lumière (3) est supérieure ou égale à 0,5 eV ;
dans laquelle les niveaux d'énergie sont déterminés par un spectromètre photo-électronique à rayons X ou un spectromètre photo-électronique ultraviolet comme exposé dans la description.

8. Batterie solaire en pérovskite selon l'une quelconque des revendications 1 à 7, dans laquelle une valeur de différence entre un niveau de Fermi et le niveau d'énergie maximum de la bande de valence de la seconde couche de transport de trous (22) est inférieure ou égale à 1,5 eV, et/ou
une valeur de différence entre un niveau de Fermi et le niveau d'énergie maximum de la bande de valence de la première couche de transport de trous (21) est inférieure ou égale à 1,5 eV ;
et/ou
dans laquelle une bande interdite de la seconde couche de transport de trous (22) est supérieure ou égale à 1,5 eV ;
dans laquelle les niveaux d'énergie sont déterminés par un spectromètre photo-électronique à rayons X ou un spectromètre photo-électronique ultraviolet comme exposé dans la description.

9. Batterie solaire en pérovskite selon l'une quelconque des revendications 1 à 8, dans laquelle
l'épaisseur de la seconde couche de transport de trous (22) est de 1 nm à 300 nm, et facultativement de 1 nm à 100 nm, et/ou
l'épaisseur de la première couche de transport de trous (21) est de 5 nm à 1 000 nm, et facultativement de 10 nm à 200 nm, et
facultativement, un rapport de l'épaisseur de la première couche de transport de trous (21) à l'épaisseur de la seconde couche de transport de trous (22) est de 1/1 à 10/1.

10. Batterie solaire en pérovskite selon l'une quelconque des revendications 1 à 9, dans laquelle l'une de la première électrode (1) et de la seconde électrode (5) est une électrode transparente, et facultativement, l'électrode transparente est une électrode FTO ou une électrode ITO.

11. Batterie solaire en pérovskite selon l'une quelconque des revendications 1 à 10, dans laquelle l'une de la première électrode (1) et de la seconde électrode (5) est une électrode en métal ou une électrode en carbone conducteur, et facultativement, l'électrode en métal est sélectionnée parmi une ou plusieurs parmi une électrode en or, une électrode en argent, une électrode en aluminium, et une électrode en cuivre.

12. Batterie solaire en pérovskite selon l'une quelconque des revendications 1 à 11, dans laquelle la batterie solaire en pérovskite comprend en outre une couche de transport d'électrons (4), la couche de transport d'électrons (4) est située entre la couche d'absorption de lumière (3) et la seconde électrode (5) ou la première électrode (1), et la couche d'absorption de lumière (3) est située entre la première couche de transport de trous (21) et la couche de transport d'électrons (4).

13. Ensemble photovoltaïque, comprenant la batterie solaire en pérovskite selon l'une quelconque des revendications 1 à 12.
